(19) Europäisches Patentamt / European Patent Office / Office européen des brevets

(11) EP 1 062 520 B1

(12) **EUROPÄISCHE PATENTSCHRIFT**

(45) Veröffentlichungstag und Bekanntmachung des Hinweises auf die Patenterteilung:
**23.05.2007 Patentblatt 2007/21**

(21) Anmeldenummer: **99913065.1**

(22) Anmeldetag: **01.02.1999**

(51) Int Cl.:
*G01P 15/12* *(2006.01)*    *G01P 15/08* *(2006.01)*

(86) Internationale Anmeldenummer:
**PCT/DE1999/000268**

(87) Internationale Veröffentlichungsnummer:
**WO 1999/046605 (16.09.1999 Gazette 1999/37)**

(54) **MESSVORRICHTUNG MIT MIKROSENSOR UND VERFAHREN ZU SEINER HERSTELLUNG**

MEASURING DEVICE WITH A MICROSENSOR AND METHOD FOR PRODUCING THE SAME

DISPOSITIF DE MESURE DOTE D'UN MICRODETECTEUR ET SON PROCEDE DE PRODUCTION

(84) Benannte Vertragsstaaten:
**DE FR GB**

(30) Priorität: **10.03.1998 DE 19810286**

(43) Veröffentlichungstag der Anmeldung:
**27.12.2000 Patentblatt 2000/52**

(73) Patentinhaber: **Infineon Technologies AG
81669 München (DE)**

(72) Erfinder: **WERNER, Wolfgang
D-81545 München (DE)**

(74) Vertreter: **Ginzel, Christian et al
Zimmermann & Partner,
Postfach 33 09 20
80069 München (DE)**

(56) Entgegenhaltungen:
**EP-A- 0 664 456        WO-A-97/49998
US-A- 3 247 723**

- **PATENT ABSTRACTS OF JAPAN Bd. 003, Nr. 081 (E-122), 12. Juli 1979 (1979-07-12) & JP 54 058077 A (MATSHUSHITA ELECTRIK WORKS LTD), 10. Mai 1979 (1979-05-10)**

EP 1 062 520 B1

**Beschreibung**

Die Erfindung betrifft eine Messvorrichtung mit wenigstens einem Mikrosensor sowie ein Verfahren zur Herstellung einer solchen Messvorrichtung.

Mikrosensoren und insbesondere mikromechanische Sensoren für Druck oder Beschleunigung haben in integrierten elektronischen Schaltungen große technologische Bedeutung erlangt. Die bekannten Mikrosensoren sind als piezoresistive oder kapazitive Drucksensoren für Absolut-, Relativ- und Differenzdruckmessungen ausgebildet. Sie beruhen auf dem Prinzip, dass ein Verformungskörper aus einem Halbleitermaterial unter Einwirkung einer Kraft verformt wird.

Aus der WO 95/09366 ist ein Beschleunigungssensor bekannt, der ein bewegliches Masseteil besitzt, welches über Federelemente mit einer Aufhängung verbunden ist. Das bewegliche Masseteil umfasst eine bewegliche Platte eines Kondensators. Die andere, feststehende Platte des Kondensators ist mit dem Gehäuse verbunden. Auf das Masseteil wirkende Beschleunigungen führen zu einer Auslenkung des Masseteils und damit zu einer Änderung der Kapazität des Kondensators. Diese Kapazitätsänderung kann detektiert werden.

Ferner ist aus der EP 0 664 456 A1 ein Beschleunigungssensor bekannt. Der Beschleunigungssensor umfasst wenigstens ein Temperaturfühlwiderstandsmittel, das bei Verwendung in einem geschlossenen Raum angeordnet ist, wobei ein Gas in dem geschlossenen Raum erwärmt wird, und wobei sich der Widerstand des Widerstandsmittels aufgrund eines Stroms des Gases über das Widerstandsmittel ändert.

Ferner ist aus der US 3,247,723 ein Instrument bekannt, dass empfindlich gegenüber Gasfluss ist. Das Instrument umfasst zwei Kammern, eine Menge von relativ heißem Gas in einer der Kammern, eine Menge von relativ kaltem Gas in der anderen der Kammern, und eine Wand, die beiden Kammern gemeinsam ist, und die beide Gasmengen trennt. Die Wand ist mit einem Paar paralleler Schlitze ausgestattet.

Ferner ist aus der WO 97/49998 ein Beschleunigungsmesser bekannt. Der Beschleunigungsmesser umfasst ein Substrat mit einer Aushöhlung, einen Heizdraht, der sich über die Aushöhlung erstreckt, ein Paar von Temperatursensordrähten, die sich in gleicher Distanz vom Heizdraht über die Aushöhlung erstrecken.

Ferner ist aus der JP 54 058077 A ein Detektor für ultrarote Strahlen bekannt. Der Detektor ist aus zwei Kammern aufgebaut, die über einen Verbindungsabschnitt kommunizieren, der mit einem Flussgeschwindigkeitsdetektor ausgestattet ist.

Ferner sind Drucksensoren bekannt, bei denen ein Verformungskörper aus einem Halbleitermaterial in seinem Randbereich mit einem Grundkörper verbunden ist. Bei diesem Fall ist der Verformungskörper vorzugsweise als eine dünne Membran ausgebildet. In den Bereichen der Membran, in denen eine besonders hohe mechanische Spannung auftritt, sind eine oder mehrere piezoresistive Widerstandsbahnen angeordnet. Hierdurch führt eine Auslenkung des Verformungskörpers zu einer detektierbaren elektrischen Spannung.

Die bekannten Mikrosensoren haben sich zwar in der Praxis vielfältig bewährt, sie sind jedoch mit dem Nachteil verbunden, dass für ein ausreichend großes elektrisches Signal eine entsprechend große Ausdehnung des Verformungskörpers mit entsprechend großen Abmessungen des Sensors erforderlich ist. Eine beliebige Verkleinerung für eine Integrierbarkeit in integrierte elektrische Schaltung ist nicht ohne weiteres möglich, da einerseits mikromechanische Grenzen bei der Ausbildung der Membran oder Cantilevers vorliegen oder Einschränkungen der Messgenauigkeit bzw. der erhaltenen Signalhöhe hinzunehmen sind.

Der Erfindung liegt die Aufgabe zugrunde, eine Messvorrichtung mit einem oder mehreren Mikrosensoren mit geringen Abmessungen sowie ein Verfahren zu ihrer Herstellung zur Verfügung zu stellen, die eine problemlose Integration in bestehende monolithische Halbleiterschaltungen ermöglicht, und welche gleichwohl eine hohe Genauigkeit bzw. Signalauflösung bei der Erfassung der zu messenden physikalischen Größe, wie insbesondere Druck, Beschleunigung oder Temperatur gewährleistet.

Diese Aufgabe wird durch eine Messvorrichtung nach Anspruch 1 und ein Verfahren zur Herstellung nach Anspruch 17 gelöst.

Erfindungsgemäß ist vorgesehen, dass die Messvorrichtung wenigstens einen Mikrosensor mit jeweils wenigstens zwei durch wenigstens einen Kanal miteinander verbundenen Kammern aufweist, welche Kammern mit einem Gas gefüllt sind und nach außen abgeschlossen sind und eine Detektionseinrichtung zur Erfassung des im wenigstens einen Kanal aufgrund verschiedener in den Kammern herrschender Drücke fließenden Gasstroms vorgesehen ist. Die Messvorrichtung weist ferner eine Auswerteschaltung zur Integration eines Signals der Detektionsvorrichtung auf.

Die Erfindung sieht also vor, einen Mikrosensor so auszustatten, dass er mehrere Hohlräume aufweist, wobei wenigstens ein Teil dieser Hohlräume derartig miteinander verbunden ist, dass ein in den Hohlräumen enthaltenes Gas von einem Hohlraum in einen oder mehrere andere Hohlräume fließen kann. Die Hohlräume befinden sich hierbei beispielsweise innerhalb eines Halbleitermaterials.

Dem Prinzip der Erfindung folgend wird normale Raumluft oder ein Gas wie Stickstoff als Füllgas eingesetzt. Um eine deutliche Druckänderung und somit einen ausreichenden Gasstrom zu erzielen (beispielsweise durch Beschleunigung des gesamten Mikrosensors), ist es zweckmäßig, ein Gas mit einem möglichst hohen spezifischen Gewicht und hoher Wärmekapazität einzusetzen.

In einer besonders bevorzugten Ausführung der Erfindung ist die Detektionseinrichtung durch ein ihr zugeordnetes Heiz-Kühl-Element auf eine von der Temperatur des Gases in den Kammern unterschiedliche Messtemperatur aufheizbar oder kühlbar.

Eine besonders bevorzugte Ausführungsform der Erfindung sieht vor, dass eine aufgrund des zwischen den Kammern durch den Kanal fließenden Gasstroms erfolgende Änderung der Temperatur der Detektionseinrichtung erfasst wird und die Detektionseinrichtung als Reaktion hierauf ein der Änderung der Temperatur entsprechendes elektrisches Mess-Signal am Ausgang der Detektionseinrichtung liefert.

In einer weiterhin bevorzugten Ausführungsform der Erfindung ist vorgesehen, dass das mit der Detektionseinrichtung gekoppelte Heiz-Kühl-Element durch einen elektrischen Heizwiderstand, einen Heiztransistor, eine Heizdiode oder ein Peltierelement ausgebildet ist.

Zweckmäßigerweise kann dabei in einer vorteilhaften Ausgestaltung der Erfindung die Detektionseinrichtung durch das Heiz-Kühl-Element selbst ausgebildet sein.

Eine konstruktiv besonders einfache und daher bevorzugte Ausführung der Erfindung zeichnet sich dadurch aus, dass die Detektionseinrichtung durch ein Thermoelement ausgebildet ist.

In einer weiterhin besonders bevorzugten Ausgestaltung der Erfindung ist vorgesehen, dass ein lediglich in einer Kammer mündender Referenzkanal vorhanden ist, dem eine Referenz-Detektionseinrichtung mit vorbestimmten elektrischen Eigenschaften zugeordnet ist. Vorteil hierbei ist, dass durch einen Vergleich der Signale der Detektionseinrichtung und der Referenz-Detektionseinrichtung der Einfluss der Temperatur des Mikrosensors selbst schaltungstechnisch eliminiert werden kann.

Hierbei ist in einer bevorzugten Ausgestaltung vorgesehen, dass die Detektionseinrichtung und die Referenz-Detektionseinrichtung in einer Messbrückenschaltung verschaltet sind.

Eine weitere vorteilhafte Ausführung der Erfindung sieht vor, dass eine Zusatz-Detektionseinrichtung mit vorbestimmten elektrischen Eigenschaften der Detektionseinrichtung zugeordnet ist. Dabei wird die Zusatz-Detektionseinrichtung durch den erwärmten bzw. abgekühlten Gasstrom, welcher durch die auf der Messtemperatur befindliche Detektionseinrichtung in seiner Temperatur verändert wurde, im Falle der Gasstromrichtung von der Detektionseinrichtung zur Zusatz-Detektionseinrichtung, erwärmt bzw. abgekühlt wird und als Reaktion hierauf ein elektrisches Mess-Signal an ihrem Ausgang liefert bzw. im Falle einer Gasstromrichtung von der Zusatz-Detektionseinrichtung zur Detektionseinrichtung kein Mess-Signal an ihrem Ausgang liefert. Der Vorteil dieser Anordnung liegt darin, dass die Gasstromrichtung detektiert werden kann.

Um den Gasstrom besonders gut erfassen zu können, ist nach einer weiteren Ausführungsform der Erfindung vorgesehen, dass die Detektionseinrichtung und/oder die Zusatz-Detektionseinrichtung innerhalb mindestens eines Kanals ausgebildet ist.

Sowohl die Detektionseinrichtung als auch die Referenz-Detektionseinrichtung oder die Zusatz-Detektionseinrichtung ist in einer vorteilhaften Ausgestaltung der Erfindung in oder an einem Randbereich einer Wandung angeordnet oder aus der Wandung bestehend ausgebildet. Dem folgend besteht die Wandung in einer besonders bevorzugten Ausgestaltung der Erfindung aus Halbleitermaterial.

Weiterhin bevorzugt sind die Kammern und die Kanäle und/oder der Referenzkanal des Mikrosensors in oder auf einem Halbleitersubstrat ausgebildet. Der Vorteil dieser Ausführung liegt in der Integrierbarkeit der Messvorrichtung in einer in einem Halbleitersubstrat ausgebildeten integrierten Schaltung.

Für die Erfassung eines äußeren Druckes bzw. einer Druckänderung ist in einer Ausführungsform der Erfindung eine nach au-ßen abschließende elastische Membran vorgesehen.

Eine weiterhin bevorzugte vorteilhafte Ausgestaltung der Erfindung zeichnet sich dadurch aus, dass eine Vielzahl von Mikrosensoren in Zeilen und Spalten matrixförmig angeordnet sind und vermittels einer Ansteuerschaltung einzeln ansteuerbar sind. Von Vorteil hierbei ist, dass vermittels des Sensors flächig Daten in hoher Auflösung, die erst durch die Kleinheit der Mikrosensoren möglich wird, erfasst werden können.

Die Erfindung betrifft ferner ein Verfahren zur Herstellung eines monolithisch in oder auf einem Substrat ausgebildeten Mikrosensors. Dabei ist vorgesehen, dass wenigstens zwei Kammern mit wenigstens einem die Kammern verbindenden Kanal sowie ein lediglich in eine Kammer mündender Referenzkanal ausgebildet werden. Hiernach wird eine Detektionseinrichtung zur Erfassung eines im wenigstens einen Kanal fließenden Gasstroms, welcher Gasstrom aufgrund verschiedener in den Kammern herrschender Drücke zustande kommt, ausgebildet. Im nächsten Schritt werden die Kammern, die Kanäle und der Referenzkanal mit einem Gas aufgefüllt und nach außen gasdicht verschlossen. In dem Verfahren wird ferner eine Auswerteschaltung zur Integration eines Signals der Detektionseinrichtung ausgebildet.

Das Verschließen der Kammern und des wenigstens einen die Kammern verbindenden Kanals erfolgt in einem besonders bevorzugten Verfahrensschritt durch das Verfließen eines Abdeckmaterials. Dabei ist das Abdeckmaterial bevorzugterweise so beschaffen, dass die Kammern und die Kanäle sowie der Referenzkanal nicht ausgefüllt werden. Hierbei erfolgt das Verfließen des Abdeckmaterials in einem weiterhin bevorzugten Verfahrensschritt in Anwesenheit eines für die Füllung der Kammern bestimmten Gases.

Bei einem besonders bevorzugten Verfahren werden die Kammern, der mindestens eine die Kammern verbindende Kanal sowie der Referenzkanal in oder auf dem Substrat und die Detektionseinrichtung sowie die Referenz- und die Zusatz-Detektionseinrichtung durch die folgenden Prozess-Schritte gefertigt:

- Beschichten des Substrats mit einer Opferschicht, die insbesondere aus $SiO_2$ besteht,
- Strukturierung der Detektionseinrichtung sowie der Referenz- und der Zusatz-Detektionseinrichtung mit deren Zuleitungen auf der Opferschicht, insbesondere vermittels eines Ätzverfahrens,
- Aufbringen einer zweiten Opferschicht,
- Aufbringen einer ersten Abdeckschicht, insbesondere aus polykristallinem Silizium,
- Versehen der Abdeckschicht mit Löchern wenigstens teilweise in den Bereichen, unter denen die Kammern und/ oder Kanäle hergestellt werden sollen, und
- Herausätzen der beiden Opferschichten durch die Löcher in der Abdeckschicht zur Herstellung der Kammern und/ oder Kanäle.

Um eine Diffusion des Gases in das die Wandung bildende Halbleitermaterial zu verhindern, ist es zweckmäßig, in einem weiteren bevorzugten Verfahrensschritt vor dem Verschließen der Kammern wenigstens einen Teil der den Kammern und/oder der dem Kanal zugewandten Flächen des Halbleitersubstrats mit einer Blockerschicht zu versehen. Von Vorteil hierbei ist auch, dass eine Reaktion des Füllgases mit den Oberflächen verhindert wird.

Die erfindungsgemäßen Mikrosensoren zeichnen sich neben ihren vorteilhaften Eigenschaften und ihrer leichten Herstellbarkeit auch durch ihre vielfältigen Anwendungsmöglichkeiten aus.

So ist es möglich, einen erfindungsgemäßen Mikrosensor als Beschleunigungssensor, als Drucksensor oder als Temperatursensor einzusetzen.

Weitere Vorteile, Besonderheiten und zweckmäßige Weiterbildungen der Erfindung ergeben sich aus den Unteransprüchen.

Nachfolgend wird ein bevorzugtes Ausführungsbeispiel der Erfindung anhand der Zeichnungen weiter erläutert. Es zeigen:

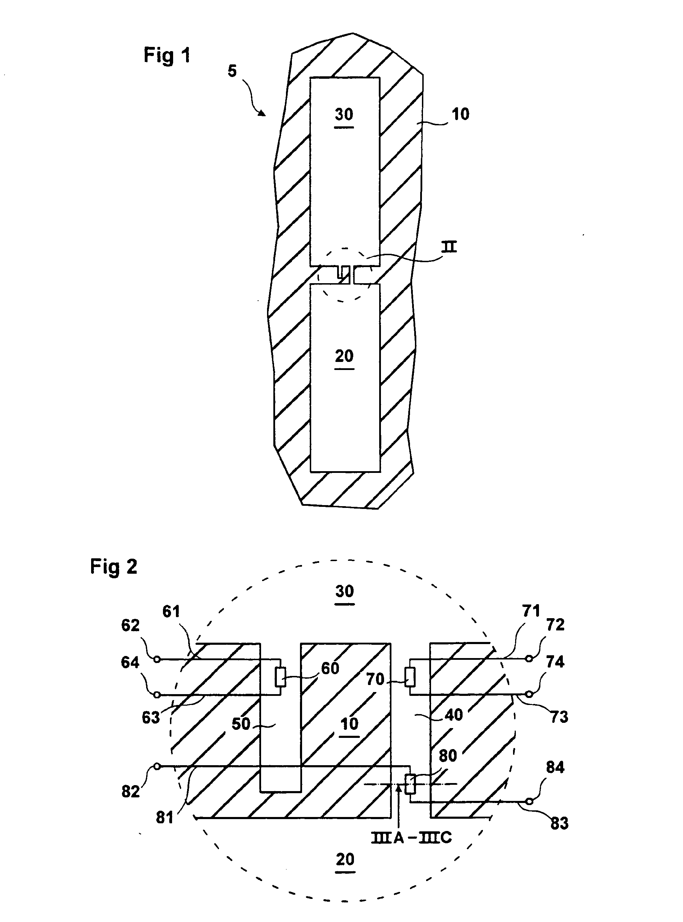

Figur 1            eine schematische Schnittansicht einer erfindungsgemäßen Messvorrichtung mit einem Mikrosensor;

Figur 2            einen vergrößerten Ausschnitt eines Teilbereichs II aus Figur 1; und

Figuren 3A bis 3C   schematische Schnittansichten zur Erläuterung eines Verfahrens zur Herstellung eines erfindungsgemäßen Mikrosensors.

Die erfindungsgemäße Messvorrichtung mit wenigstens einem Mikrosensor kann sowohl als Beschleunigungssensor, als Drucksensor oder als Temperatursensor ausgestaltet sein. Bei jeder dieser Ausgestaltungen kann das gleiche Grundkonzept eingesetzt werden. Das Grundprinzip der Beschleunigungs-, Druck- oder Temperaturmessung beruht bei der erfindungsgemäßen Messvorrichtung auf der Detektion eines Gasstromes, der aufgrund der zu messenden Größe entstanden ist. Hierzu sind zwei gasdicht abgeschlossene mit einem Gas gefüllte Kammern durch einem Kanal miteinander verbunden. Durch diesen Kanal gleichen sich in den beiden Kammern herrschende Druckunterschiede durch einen sich einstellenden Gasstrom aus. Der Druckunterschied kann hierbei durch eine Beschleunigung des in der Messvorrichtung integrierten Mikrosensors oder eine Temperaturänderung des Gases in einer Kammer erreicht werden. Der Gasstrom wird vorzugsweise direkt im die Kammern verbindenden Kanal mit einer Detektionseinrichtung detektiert, und in ein elektrisches Signal umgewandelt.

Das in den Figuren dargestellte Ausführungsbeispiel einer erfindungsgemäßen Messvorrichtung umfasst wenigstens einen Mikrosensor, der zwei mit einem Gas gefüllte Kammern 20, 30 aufweist, wobei die Kammern 20, 30 durch einen Kanal 40 miteinander verbunden sind, die Kammern 20, 30 im Übrigen gasdicht nach außen abgeschlossen sind, und eine Detektionseinrichtung 70 zur Erfassung eines im Kanal 40 fließenden Gasstroms vorgesehen ist, welcher Gasstrom aufgrund verschiedener in den Kammern herrschender Drücke zustande kommt. Der Detektionseinrichtung 70 ist ein Heiz-Kühl-Element zugeordnet, vermittels welchem die Detektionseinrichtung auf eine von der Temperatur des Gases in den Kammern 20, 30 unterschiedliche Messtemperatur aufheizbar oder kühlbar ist.

Bei dem in den Figuren gezeigten Ausführungsbeispiel befinden sich die beiden Kammern 20 und 30 in einem Halbleitersubstrat 10. Die Kammern 20 und 30 weisen vorzugsweise Abmessungen im Millimeter-Bereich auf. Beispielsweise sind die Kammern 20 und 30 jeweils einen Millimeter breit, zwei Mikrometer hoch und drei Millimeter lang. Der die Kammern 20 und 30 miteinander verbindende Kanal 40 weist eine Querschnittsfläche im Mikrometer-Bereich, beispielsweise 1 bis 10 $\mu m^2$, auf. Vorzugsweise ist die Länge des Kanals um einen Faktor 2 bis 10 größer als seine Breite. Im vorliegenden Fall beträgt die Länge des Kanals 40 ungefähr 10 $\mu m$.

Zur Detektion des Gasstromes ist die durch einen Widerstand ausgebildete Detektionseinrichtung 70 im Kanal 40 angeordnet. Der durch eine nicht dargestellte Heizung oder einen durch ihn geführten Strom auf Messtemperatur geheizte Widerstand 70 wird durch den durch den Kanal 40 führenden Gasstrom abgekühlt.

Der Widerstand 70 besitzt vor dem Einsetzen eines Gasstromes eine bestimmte Messtemperatur, und ändert durch den Kühleffekt des an ihm vorbei streichenden Gasstromes entsprechend seinem Temperaturkoeffizienten seinen Widerstandswert; auf diese Weise variiert der zu seiner Aufheizung durch ihn geführten Strom bzw. die an ihm abfallende Spannung. Das entsprechende elektrische Signal kann an den aus dem Mikrosensor herausführenden Leiterbahnen 71 und 73 bzw. den Ausgängen 72 und 74 abgegriffen werden. Bei einem linearen Temperaturkoeffizienten ist die Widerstandsänderung in erster Näherung proportional zu dem Gasstrom durch den Kanal 40. Die Richtung des Gasstroms und damit das Vorzeichen der zu messenden Größe kann durch eine durch einen ungeheizten Widerstand 80 ausgebildete Zusatz-Detektionseinrichtung 80 detektiert werden. Dieser ungeheizte Widerstand 80 ist in räumlicher Nähe zum geheizten Widerstand 70 angeordnet und erfährt durch einen vom Widerstand 70 in Richtung zum Widerstand 80 führenden Gasstrom eine Erwärmung, da der Gasstrom über dem geheizten Widerstand 70 erwärmt wurde. Da dies nur bei einer Gasstromrichtung vom geheizten Widerstand 70 zum ungeheizten Widerstand 80 geschieht, stellt sich im Falle einer entgegengesetzten Gasstromrichtung keine Temperaturänderung des Widerstandes 80 ein. Eine sich im Falle einer Erwärmung des Widerstandes 80 entsprechend seinem Temperaturkoeffizienten einstellende Widerstandsänderung ist über die aus dem Mikrosensor herausführenden Leiterbahnen 81 und 83 bzw. die Ausgänge 82 und 84 abgreifbar.

Um Einflüsse durch die Eigentemperatur des Mikrosensors 5 auf das zu messende Signal zu verhindern, ist eine durch einen Widerstand 60 ausgebildete Referenz-Detektionseinrichtung 60 vorgesehen. Hierbei ist der Widerstand 60 in einem dem Kanal 40 in seinen Dimensionen ähnlichen Referenzkanal 50 angeordnet. Der Referenzkanal 50 befindet sich parallel zu dem Kanal 40 in dem Halbleitersubstrat 10, und ist lediglich mit der Kammer 30 verbunden, sodass sich in ihm kein Gasstrom ausbilden kann. Der Referenzkanal 50 weist im Wesentlichen den gleichen Querschnitt wie der Kanal 40 auf. Seine Länge ist jedoch etwas geringer, sodass der Referenzkanal 50 vor der anderen Kammer 20 endet.

Um die Temperatureinflüsse des Mikrosensors auszuschließen, kann der Widerstand 70 mit dem Widerstand 60 zusammen in eine (nicht näher dargestellte) Brückenschaltung einbezogen werden, sodass nur ein Gasfluss wischen den Kammern ein entsprechendes Signal erzeugen kann.

Die Widerstände 60, 70 und 80 können grundsätzlich aus jedem beliebigen Material bestehen. Insbesondere Metalle oder hochdotierte Halbleiter kommen als Materialien für die Widerstände in Betracht. Der Einsatz von hochdotierten Halbleitermaterialien für die Widerstände 60, 70 und 80 hat den Vorteil, dass die Widerstände 60, 70 und 80 besonders einfach in dem Herstellungsprozess des die Messvorrichtung beinhaltenden integrierten Schaltkreises hergestellt werden können.

Es ist auch möglich, die Detektionseinrichtung 70 und/oder die Referenz- 60 und Zusatz-Detektionseinrichtung 80 vor einer Öffnung des Kanals 40 bzw. Referenzkanals 50 anzuordnen bzw. auszubilden. Die Detektionseinrichtung 70 und/oder die Referenz- 60 und Zusatz-Detektionseinrichtung 80 können weiterhin durch einen Teilbereich des die Wandung bildenden Halbleitermaterials des Kanals 40 bzw. des Referenzkanals 50 ausgebildet bzw. ausgewiesen sein oder durch einen Teilbereich des die Wandung bildenden Halbleitermaterials ausgebildet bzw. ausgewiesen sein, welcher vor einer Öffnung eines Kanals 40 liegt.

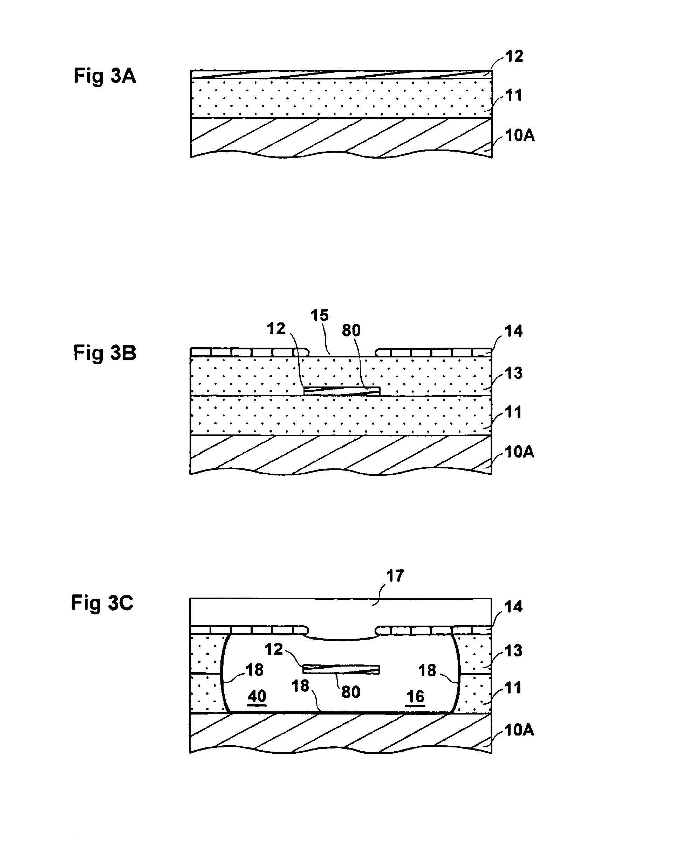

Das Verfahren zur Herstellung umfasst die in den Figuren 3A bis 3C näher dargestellten Schritte:

Nach Figur 3A wird eine vorzugsweise aus Silizium bestehende Trägerschicht 10A mit einer aus $SiO_2$ bestehenden ersten Opferschicht 11 bedeckt. Die erste Opferschicht 11 weist vorzugsweise eine Dicke zwischen 0,5 $\mu$m und 5 $\mu$m auf.

Danach wird gemäß Figur 3A eine elektrisch leitfähige Strukturierungschicht 12 zur Bildung von Widerständen 60, 70, 80 abgeschieden. Diese Schicht besteht vorzugsweise aus dotiertem polykristallinen Silizium. Eine Strukturierung der Strukturierungschicht 12 erfolgt mit aus der Halbleitertechnologie bekannten Photolithographie- und Ätzverfahren. Die Strukturierung geschieht vorzugsweise so, dass sowohl die Widerstände 60, 70 und 80 als auch deren Zuleitungen 61, 63, 71, 73, 81, und 83 entstehen.

Nach der Bildung der Widerstände 60, 70 und 80 und der Zuleitungen 61, 63, 71, 73, 81, und 83 wird eine zweite Opferschicht 13 gemäß Figur 3B abgeschieden. Die zweite Opferschicht 13 weist vorzugsweise die gleiche Dicke auf wie die erste Opferschicht 11.

Auf die zweite Opferschicht 13 wird gemäß Figur 3B eine Abdeckschicht 14 aufgebracht. Die Abdeckschicht 14 besteht beispielsweise aus polykristallinem Silizium. Die Abdeckschicht 14 wird mit gleichfalls aus der Halbleitertechnologie bekannten Photolithographie- und Ätzverfahren in Bereichen mit Ätzöffnungen 15 versehen, unter denen in einem späteren Prozess-Schritt ein Hohlraum 16 in Form von Kammern oder Kanälen gefertigt wird.

Durch die Ätzöffnungen 15 in der Abdeckschicht 14 werden die beiden Opferschichten 11 und 13 selektiv herausgeätzt, so dass gemäß Figur 3C die Kammern 20, 30 und der Kanal 40 sowie der Referenzkanal 50 entstehen.

Gegebenenfalls kann nun wenigstens ein Teil der in dem Substrat 10 erzeugten Flächen, die die zwei Kammern 20, 30 und den die Kammern verbindenden Kanal 40 sowie den Referenzkanal 50 bilden, vor dem Verschließen mit einer eine Diffusion des Füllgases in das umgebende Halbleitermaterial 10 verhindernden oder wenigstens vermindernden Blockerschicht 18 versehen werden (Figur 3C).

Durch eine Beschichtung der Abdeckschicht 14 mit einem Abdeckmaterial 17 - beispielsweise Fließglas (vorzugsweise Bor-Phosphor-Silikatglas, BPSG) - und anschließendes Verfließen werden die Ätzöffnungen 15 in der Abdeckschicht 14 gemäß Figur 3C verschlossen. Bei BPSG ist es zweckmäßig, dieses Verfließen bei einer Temperatur von ungefähr 800 °C bis 1100 °C durchzuführen.

Das Verschließen erfolgt in einer Gasatmosphäre, gegebenenfalls bei höheren Drücken, um die Kammern mit einem gewünschten Gas zu füllen.

Nachfolgend wird die Funktionsweise der erfindungsgemäßen Messvorrichtung, der als Beschleunigungssensor arbeitet, näher erläutert.

Entsprechend der barometrischen Höhenformel $\left( p = p_o \exp\left[ \dfrac{\rho_o g_o}{p_o} h \right] \right)$ ist der Druck in einer Gassäule abhängig vom spezifischen Gewicht $\rho_o$ des Gases, der Beschleunigung $g_o$ und der Höhe h. Für ein abgeschlossenes System kleiner Abmessung gilt für den Druck $p = p_a + \rho_o g h_o$, wobei $h_o$ die wirksame Höhendifferenz und $p_a$ der statische Innendruck ist. Eine Änderung der Beschleunigung $\Delta g$ führt zu einem Druckunterschied $\Delta p = \rho_o h_o \Delta g$ zwischen beiden Kammern. Verwendet man ein schweres Gas mit $\rho_o \approx 10$ kg/m$^3$ (z.B. SF$_6$, Xenon) so ergibt sich für eine Änderung der Beschleunigung um $\Delta g = 1\ g_o$ (Erdbeschleunigung) und h = 3 mm eine Druckdifferenz von $\Delta p \approx 0,3$ Pa. Bei einem statischen Innendruck von 1 at $\approx 10^5$ Pa bedeutet dies eine Druckänderung zwischen den Kammern 20 und 30 von

$$\frac{\Delta p}{p_a} \cdot \frac{0,3\,\text{Pa}}{10^5\,\text{Pa}} = 0,3 x 10^{-5}$$

. Bei einem Kammervolumen von V = 3 x 10$^3$ x 10$^3$ x 2$\mu$m$^3$ und einem Kanalquerschnitt

von a = 1 x 1 $\mu$m$^2$ bedeutet dies, dass eine Gassäule mit einer Länge von

$$V \frac{\Delta p}{p_a} \cdot \frac{1}{a} = 6 \cdot 10^6\,\mu\text{m}^3 \cdot 0,3 \cdot 10^{-5} \cdot \frac{1}{1\mu\text{m}^2} \approx 20\mu\text{m}$$

am Widerstand vorbeiströmt und eine entsprechende Änderung der Leitfähigkeit des Widerstands 70 durch Abkühlung desselben hervorruft. Die Empfindlichkeit des Systems kann durch die Parameter $\rho_o$, V und $h_o$ eingestellt werden. Gemessen wird die Ableitung dg/dt der Beschleunigung. Für ein Airbagsystem mit einem Messbereich von 0 bis 50 g kann mit den oben beispielhaft gewählten Parametern eine ausreichende Genauigkeit erreicht werden. Eine Funktionsprüfung ohne Beschleunigung des Systems ist möglich durch einen in einer der beiden Kammern eingebauten Heizwiderstand, der bei Inbetriebnahme zu einem Gasstrom im Kanal zwischen den Kammern führt.

Nachfolgend wird dargestellt, wie die erfindungsgemäße Messvorrichtung als Drucksensor arbeitet.

Hierzu wird die Anordnung entsprechend den Figuren so ausgeführt, dass eine der Kammern von einer elastischen Membran begrenzt wird. Bei einer Auslenkung der Membran um 1% der Kammerdicke a fließt eine Gassäule mit folgender Länge am Widerstand 70 vorbei:

$$\Delta p = \frac{P_a \cdot \Delta V}{V} = 10^5\,\text{Pa} \cdot 0,01 = 10^3\,\text{Pa}.$$

$$L_{\text{Gassäule}} = V \cdot \frac{\Delta p}{p_a} \cdot \frac{1}{a} = 3 \times 10^3 \times 10^3 \times 2\,\mu\text{m}^3 \cdot 0,01 \cdot \frac{1}{1\mu\text{m}^2} = 6 \cdot 10^4\,\mu\text{m}$$

$V$ = Volumen einer Kammer
statischer Druck in den Kammern $p_a$ = 10$^5$ Pa

Reduziert man die Abmessung der Kammern 20, 30 auf zum Beispiel 100 x 100 x 2 $\mu$m$^3$, so fließt eine Gassäule mit einer Länge von 200 $\mu$m am Widerstand vorbei. Dies bedeutet, dass mit einer Kammerfläche von nur 0,01 mm$^2$ ein sehr empfindliches Druckmesssystem aufgebaut werden kann. Wie bei einem Beschleunigungsmesser wird auch hier die Ableitung des Druckes gemessen. Um den Druck als Ausgangsgröße zu erhalten, beinhaltet die elektronische Signalauswertung eine Integration des Signals.

Sind beide Kammern 20, 30 von einer elastischen Membran begrenzt, so kann mit der erfindungsgemäßen Anordnung auch ein Differenzdrucksensor aufgebaut werden.

Eine weitere Ausgestaltung des in den Figuren dargestellten Mikrosensors als Temperatursensor ist beispielsweise dadurch möglich, dass eine der Kammern mit einer Schicht versehen wird, die Wärmestrahlung absorbiert, während die andere Kammer so gestaltet ist, dass sie Wärmestrahlung reflektiert. So kann mit dieser Anordnung ein sehr empfindliches Temperaturmesssystem aufgebaut werden. Wird die Gesamttemperatur in einer Kammer um zum Beispiel 1 °C erhöht, so fließt eine Gassäule mit folgender Länge am Widerstand 70 vorbei:

$$\frac{P \cdot V}{T} = const; V = const.$$

$$\frac{\Delta p}{p} = \frac{\Delta T}{T} = \frac{1}{300}$$

$$L_{Gassäule} = V \cdot \frac{\Delta p}{p} \cdot \frac{1}{a} = 3 \times 10^3 \times 10^3 \times 2\mu m^3 \cdot \frac{1}{300} \cdot \frac{1}{1 \cdot \mu m^2} = 2 \cdot 10^4 \, \mu m$$

Bei einer Kammerfläche von beispielsweise nur 0,01 mm$^2$ und einer Temperaturänderung von 0,1 °C fließt bereits eine Gassäule von 7 $\mu$m Länge an dem Widerstand 70 vorbei.

Die Messvorrichtung kann auch eine Vielzahl der beschriebenen Temperaturmikrosensoren in einem ein- oder zweidimensionalen Feld (Array) angeordnet aufweisen, welche Mikrosensoren mit der Auswerteschaltung monolithisch integriert werden und vermittels welcher sie einzeln ansprechbar sind. Eine solche Anordnung kann beispielsweise als Sensorelement in einer Infrarotkamera eingesetzt werden. Eine Integration mit einer Auswerteschaltung ist auch bei den anderen Ausführungsformen möglich.

Zu beachten ist, dass bei der Messanordnung für Beschleunigung, Druck oder Temperatur der Betriebsdruck p$_a$ wegen $\frac{P \cdot V}{T} = const.$ temperaturabhängig ist, was zur Folge hat, dass bei einem gegebenen Signal ($\Delta$g, $\Delta$p, $\Delta$T) die Länge der Gassäule von der Temperatur abhängt. Eine entsprechende Temperaturkompensation über die Heizung des Widerstands 70 kann dies korrigieren.

**Patentansprüche**

1. Messvorrichtung mit wenigstens einem Mikrosensor (5), bei welcher Messvorrichtung das Folgende gilt:

   - der wenigstens eine Mikrosensor (5) weist wenigstens zwei mit einem Gas gefüllte Kammern (20,30) auf,
   - die Kammern (20,30) sind durch eine Durchführung miteinander verbunden,
   - die Kammern (20,30) sind im Übrigen gasdicht nach außen abgeschlossen, und

   **dadurch gekennzeichnet, dass**
   die Durchführung als Kanal (40) ausgebildet ist, in dem eine Detektionsvorrichtung (70) zur Erfassung eines im Kanal (40) aufgrund verschiedener in den Kammern herrschender Drücke fließenden Gasstroms vorgesehen ist, und dass
   die Messvorrichtung eine Auswerteschaltung zur Integration eines Signals der Detektionsvorrichtung (70) aufweist.

2. Messvorrichtung nach Anspruch 1,

**dadurch gekennzeichnet,**
**dass** der Detektionseinrichtung (70) ein Heiz-Kühl-Element zugeordnet ist, vermittels welchem die Detektionseinrichtung auf eine von der Temperatur des Gases in den Kammern (20, 30) unterschiedliche Messtemperatur aufheizbar oder kühlbar ist.

3. Messvorrichtung nach einem der Ansprüche 1 oder 2,
**dadurch gekennzeichnet,**
**dass** eine aufgrund des zwischen den Kammern (20, 30) durch den Kanal (40) fließenden Gasstroms erfolgende Änderung der Temperatur der Detektionseinrichtung (70) erfasst wird und die Detektionseinrichtung als Reaktion hierauf ein elektrisches Mess-Signal am Ausgang (72 und 74) der Detektionseinrichtung liefert.

4. Messvorrichtung nach einem der Ansprüche 2 bis 3,
**dadurch gekennzeichnet,**
**dass** das mit der Detektionseinrichtung (70) gekoppelte Heiz-Kühl-Element durch einen elektrischen Heizwiderstand, einen Heiztransistor oder eine Heizdiode ausgebildet ist.

5. Messvorrichtung nach einem der Ansprüche 2 oder 3,
**dadurch gekennzeichnet,**
**dass** das mit der Detektionseinrichtung (70) gekoppelte Heiz-Kühl-Element durch ein Peltierelement ausgebildet ist.

6. Messvorrichtung nach einem der Ansprüche 1 bis 5,
**dadurch gekennzeichnet,**
**dass** die Detektionseinrichtung (70) durch ein Thermoelement ausgebildet ist.

7. Messvorrichtung nach einem der Ansprüche 2 bis 5,
**dadurch gekennzeichnet,**
**dass** die Detektionseinrichtung (70) durch das Heiz-Kühl-Element selbst ausgebildet ist.

8. Messvorrichtung nach einem der Ansprüche 1 bis 7,
**dadurch gekennzeichnet,**
**dass** ein lediglich in einer Kammer (30) mündender Referenzkanal (50) vorgesehen ist, dem eine Referenz-Detektionseinrichtung (60) mit vorbestimmten elektrischen Eigenschaften zugeordnet ist.

9. Messvorrichtung nach einem der Ansprüche 1 bis 8,
**dadurch gekennzeichnet,**
**dass** eine Zusatz-Detektionseinrichtung (80) mit vorbestimmten elektrischen Eigenschaften der Detektionseinrichtung (70) zugeordnet ist, welche Zusatz-Detektionseinrichtung (80) durch den erwärmten bzw. abgekühlten Gasstrom, welcher durch die auf der Messtemperatur befindliche Detektionseinrichtung (70) in seiner Temperatur verändert wurde, im Falle der Gasstromrichtung von der Detektionseinrichtung (70) zur Zusatz-Detektionseinrichtung (80), erwärmt bzw. abgekühlt wird und als Reaktion hierauf ein elektrisches Mess-Signal an ihrem Ausgang (82 und 84) liefert bzw. im Falle einer Gasstromrichtung von der Zusatz-Detektionseinrichtung (80) zur Detektionseinrichtung (70) kein Mess-Signal an ihrem Ausgang (82 und 84) liefert.

10. Messvorrichtung nach Anspruch 8,
**dadurch gekennzeichnet,**
**dass** die Detektionseinrichtung (70) und die Referenz-Detektionseinrichtung (80) in einer Messbrückenschaltung zusammengeschaltet sind.

11. Messvorrichtung nach Anspruch 9 oder 10,
**dadurch gekennzeichnet,**
**dass** sowohl die Detektionseinrichtung (70) als auch die Referenz-Detektionseinrichtung (60) oder die Zusatz-Detektionseinrichtung (80) in oder an einem Randbereich einer Wandung angeordnet oder aus der Wandung bestehend ausgebildet ist.

12. Messvorrichtung nach Anspruch 11,
**dadurch gekennzeichnet,**
**dass** die Wandung aus Halbleitermaterial besteht.

**13.** Messvorrichtung nach einem der Ansprüche 9 bis 12,
**dadurch gekennzeichnet,**
**dass** die Kammern (20, 30) und die Kanäle (40, 50) und/oder der Referenzkanal (50) des Mikrosensors (5) in einem Halbleitersubstrat (10) ausgebildet sind.

**14.** Messvorrichtung nach einem der Ansprüche 9 bis 13,
**dadurch gekennzeichnet,**
**dass** die Zusatz-Detektionseinrichtung (80) innerhalb mindestens eines Kanals (40) ausgebildet ist.

**15.** Messvorrichtung nach einem der Ansprüche 1 bis 14,
**dadurch gekennzeichnet,**
**dass** eine der Kammern (20, 30) eine nach außen abschließende elastische Membran aufweist.

**16.** Messvorrichtung nach einem der Ansprüche 1 bis 15,
**dadurch gekennzeichnet,**
**dass** die Mikrosensoren (5) in Zeilen und Spalten matrixförmig angeordnet sind und vermittels einer Ansteuerschaltung einzeln ansteuerbar sind.

**17.** Verfahren zur Herstellung einer monolithisch in einem Substrat ausgebildeten Messvorrichtung mit mindestens einem Mikrosensor (5), mit den Schritten:

- Ausbilden wenigstens zweier Kammern (20, 30) mit einer die Kammern (20, 30) verbindenden Durchführung,
- Ausbilden einer Detektionseinrichtung (70) zur Erfassung eines in der Durchführung fließenden Gasstroms, welcher Gasstrom aufgrund verschiedener in den Kammern (20, 30) herrschender Drücke zustande kommt,
- Auffüllen der Kammern (20, 30) und der Durchführung mit einem Gas, und
- gasdichtes Verschließen der Kammern (20, 30) nach außen.

**dadurch gekennzeichnet,**
**dass** die Durchführung als Kanal (40) ausgebildet wird, in dem die Detektionsvorrichtung (70) angeordnet wird und
**dass** zusätzlich ein lediglich in eine Kammer (30) mündender Referenzkanal (50) ausgebildet wird,
und **dass** das Verfahren des Weiteren den Schritt umfasst:

- Ausbilden einer Auswerteschaltung zur Integration eines Signals der Detektionseinrichtung.

**18.** Verfahren nach Anspruch 17,
**dadurch gekennzeichnet, dass**
das Verschließen der Kammern (20, 30) und der wenigstens eine die Kammern verbindende Kanal (40) durch das Verfließen eines Abdeckmaterials (17) erfolgt, wobei das Abdeckmaterial so beschaffen ist, dass die Kammern und die Kanäle sowie der Referenzkanal (50) nicht ausgefüllt werden.

**19.** Verfahren nach Anspruch 18,
**dadurch gekennzeichnet, dass**
das Verfließen des Abdeckmaterials (17) in Anwesenheit eines für die Füllung der Kammern (20, 30) bestimmten Gases erfolgt.

**20.** Verfahren nach Anspruch 18 oder 19,
**dadurch gekennzeichnet, dass**
das Abdeckmaterial (17) Bor-Phosphor-Silikatglas (BPSG) ist.

**21.** Verfahren nach Anspruch 17,
**dadurch gekennzeichnet, dass**
die Kammern (20, 30), der mindestens eine die Kammern verbindende Kanal (40) sowie der Referenzkanal (50) in dem Substrat (10) sowie die Detektionseinrichtung (60) sowie die Referenz- und die Zusatz-Detektionseinrichtung (70 und 80) durch die folgenden Prozess-Schritte gefertigt werden:

- Beschichten des Substrats (10) mit einer Opferschicht (11), beispielsweise $SiO_2$,
- Strukturierung der Detektionseinrichtung (60) sowie der Referenz- und der Zusatz-Detektionseinrichtung (70 und 80) mit deren Zuleitungen (61, 63, 71, 73, 81, 83) auf der Opferschicht (11), beispielsweise vermittels eines Ätzverfahrens,
- Aufbringen einer zweiten Opferschicht (13),
- Aufbringen einer Abdeckschicht (14), beispielsweise aus polykristallinem Silizium,
- Versehen der Abdeckschicht (14) mit Löchern (15) wenigstens teilweise in den Bereichen unter denen die Kammern (20, 30) und/oder Kanäle (40, 50) hergestellt werden sollen,
- Herausätzen der beiden Opferschichten (11 und 13) durch die Löcher (15) in der Abdeckschicht (14) zur Herstellung der Kammern (20, 30) und/oder Kanäle (40, 50).

**22.** Verfahren nach einem der Ansprüche 17 bis 21,
**dadurch gekennzeichnet, dass**
wenigstens ein Teil der in dem Substrat (10) erzeugten Flächen, die die mindestens zwei Kammern (20, 30) und den wenigstens einen die Kammern verbindenden Kanal (40) sowie den Referenzkanal (50) bilden, vor dem Verschließen vermittels des Abdeckmaterials (17) mit einer eine Diffusion des Füllgases in das umgebende Halbleitermaterial (10) verhindernden oder wenigstens vermindernden Blockerschicht (18) versehen wird.

**Claims**

**1.** Measuring apparatus having at least one microsensor (5), in which measuring apparatus the following holds true:

- the at least one microsensor (5) has at least two chambers (20, 30) filled with a gas,
- the chambers (20, 30) are connected to one another by a bushing,
- the chambers (20, 30) are, moreover, sealed off to the outside in a gastight manner, and

**characterized**
**in that** the bushing is designed as a channel (40), in which there is provided a detection apparatus (70) for detecting a gas stream flowing in the channel (40) on account of different pressures prevailing in the chambers, and in that the measuring apparatus has an evaluation circuit for integration of a signal of the detection apparatus (70) .

**2.** Measuring apparatus according to Claim 1,
**characterized**
**in that** the detection device (70) is assigned a heating/cooling element by means of which the detection device can be heated or cooled to a measurement temperature which differs from the temperature of the gas in the chambers (20, 30).

**3.** Measuring apparatus according to either of Claims 1 and 2,
**characterized**
**in that** a change in the temperature of the detection device (70) is detected, said change taking place on account of the gas stream flowing between the chambers (20, 30) through the channel (40), and the detection device, as a reaction to this, supplies an electrical measurement signal at the output (72 and 74) of the detection device.

**4.** Measuring apparatus according to one of Claims 2 to 3,
**characterized**
**in that** the heating/cooling element coupled to the detection device (70) is formed by an electrical heating resistor, a heating transistor or a heating diode.

**5.** Measuring apparatus according to either of Claims 2 and 3,
**characterized**
**in that** the heating/cooling element coupled to the detection device (70) is formed by a Peltier element.

**6.** Measuring device according to one of Claims 1 to 5,
**characterized**
**in that** the detection device (70) is formed by a thermoelement.

**7.** Measuring apparatus according to one of Claims 2 to 5,
**characterized**
**in that** the detection device (70) is formed by the heating/cooling element itself.

**8.** Measuring apparatus according to one of Claims 1 to 7,
**characterized**
**in that** a reference channel (50) which opens only in a chamber (30) is provided, a reference detection device (60) having predetermined electrical properties being assigned to said reference channel.

**9.** Measuring apparatus according to one of Claims 1 to 8,
**characterized**
**in that** an additional detection device (80) having predetermined electrical properties is assigned to the detection device (70), which additional detection device (80) is heated or cooled by the heated or cooled gas stream, respectively, the temperature of which has been altered by the detection device (70) at the measurement temperature, in the case of the gas stream direction from the detection device (70) to the additional detection device (80), and, as a reaction to this, supplies an electrical measurement signal at its output (82 and 84) and, in the case of a gas stream direction from the additional detection device (80) to the detection device (70), supplies no measurement signal at its output (82 and 84).

**10.** Measuring apparatus according to Claim 8,
**characterized**
**in that** the detection device (70) and the reference detection device (80) are connected together in a measuring bridge circuit.

**11.** Measuring apparatus according to Claim 9 or 10,
**characterized**
**in that** both the detection device (70) and the reference detection device (60) or the additional detection device (80) are arranged in or on an edge region of a wall or are formed so as to comprise the wall.

**12.** Measuring apparatus according to Claim 11,
**characterized**
**in that** the wall is composed of semiconductor material.

**13.** Measuring apparatus according to one of Claims 9 to 12,
**characterized**
**in that** the chambers (20, 30) and the channels (40, 50) and/or the reference channel (50) of the microsensor (5) are formed in a semiconductor substrate (10).

**14.** Measuring apparatus according to one of Claims 9 to 13,
**characterized**
**in that** the additional detection device (80) is formed within at least one channel (40).

**15.** Measuring apparatus according to one of Claims 1 to 14,
**characterized**
**in that** one of the chambers (20, 30) has an elastic diaphragm effecting sealing-off to the outside.

**16.** Measuring apparatus according to one of Claims 1 to 15,
**characterized**
**in that** the microsensors (5) are arranged in matrix form in rows and columns and can be driven by means of a drive circuit.

**17.** Method for producing a measuring apparatus having at least one microsensor (5), said apparatus being formed monolithically in a substrate, having the following steps:

- formation of at least two chambers (20, 30) with a bushing connecting the chambers (20, 30),
- formation of a detection device (70) for detecting a gas stream flowing in the bushing, which gas stream arises on account of different pressures prevailing in the chambers (20, 30),
- filling of the chambers (20, 30) and of the bushing with a gas, and
- gastight closure of the chambers (20, 30) to the outside,

**characterized**
**in that** the bushing is formed as a channel (40), in which the detection apparatus (70) is arranged, and

**in that** a reference channel (50), which opens only into one chamber (30), is additionally formed, and
**in that** the method furthermore comprises the following step:

- formation of an evaluation circuit for integration of a signal of the detection device.

18. Method according to Claim 17,
**characterized in that**
the closure of the chambers (20, 30) and the at least one channel (40) connecting the chambers is effected by the flowing of a covering material (17), the covering material being of a nature such that the chambers and the channels and also the reference channel (50) are not fully filled.

19. Method according to Claim 18,
**characterized in that**
the flowing of the covering material (17) takes place in the presence of a gas intended for the filling of the chambers (20, 30).

20. Method according to Claim 18 or 19,
**characterized in that**
the covering material (17) is borophosphorus silicate glass (BPSG).

21. Method according to Claim 17,
**characterized in that**
the chambers (20, 30), the at least one channel (40) connecting the chambers, and also the reference channel (50) in the substrate (10) and also the detection device (60) and also the reference and the additional detection devices (70 and 80) are fabricated by the following process steps:

- coating of the substrate (10) with a sacrificial layer (11), for example $SiO_2$,
- patterning of the detection device (60) and also of the reference and the additional detection devices (70 and 80) with their leads (61, 63, 71, 73, 81, 83) on the sacrificial layer (11), for example by means of an etching method,
- application of a second sacrificial layer (13),
- application of a covering layer (14), for example made of polycrystalline silicon,
- provision of the covering layer (14) with holes (15) at least partially in the regions under which the chambers (20, 30) and/or channels (40, 50) are intended to be produced,
- etching out of the two sacrificial layers (11 and 13) through the holes (15) in the covering layer (14) for the purpose of producing the chambers (20, 30) and/or channels (40, 50).

22. Method according to one of Claims 17 to 21,
**characterized in that**
at least a portion of the areas which are produced in the substrate (10) and form the at least two chambers (20, 30) and the at least one channel (40) connecting the chambers, and also the reference channel (50), is provided, prior to closure by means of the covering material (17), with a blocker layer (18) which prevents or at least reduces diffusion of the filling gas into the surrounding semiconductor material (10).

**Revendications**

1. Dispositif de mesure comprenant au moins un microcapteur (5), dispositif de mesure dans lequel on a ce qui suit :

- le au moins un microcapteur (5) a au moins deux chambres (20, 30) emplies d'un gaz,
- les chambres (30, 30) communiquent entre elles par un passage,
- les chambres (20,30) sont, pour le reste, fermées d'une manière étanche au gaz vis-à-vis de l'extérieur, et

**caractérisé en ce que**
le passage est constitué sous la forme d'un canal (40) dans lequel est prévu un dispositif (70) de détection pour la détection d'un courant gazeux passant dans le canal (40) en raison de diverses pressions régnant dans les chambres, et **en ce que**
le dispositif de mesure a un circuit d'exploitation pour intégrer un signal du dispositif (70) de détection.

**2.** Dispositif de mesure suivant la revendication 1,
**caractérisé en ce que**
au dispositif (70) de détection est associé un élément de chauffage-refroidissement au moyen duquel le dispositif de détection peut être chauffé ou refroidi à une température de mesure différente de la température du gaz dans les chambres (20, 30).

**3.** Dispositif de mesure suivant l'une des revendications 1 ou 2,
**caractérisé en ce que**
une modification de la température du dispositif (70) de détection se produisant en raison du courant gazeux passant entre les chambres (20, 30) dans le canal (40) est détectée et le dispositif de détection fournit en réaction à cela un signal électrique de mesure à la sortie (72 et 74) du dispositif de détection.

**4.** Dispositif de mesure suivant l'une des revendications 2 à 3,
**caractérisé en ce que**
l'élément de chauffage-refroidissement couplé au dispositif (70) de détection est constitué par une résistance électrique de chauffage, un transistor de chauffage ou une diode de chauffage.

**5.** Dispositif de mesure suivant l'une des revendications 2 ou 3,
**caractérisé en ce que**
l'élément de chauffage-refroidissement couplé au dispositif (70) de détection est constitué par un élément à effet Peltier.

**6.** Dispositif de mesure suivant l'une des revendications 1 à 5,
**caractérisé en ce que**
le dispositif (70) de détection est constitué par un thermocouple.

**7.** Dispositif de mesure suivant l'une des revendications 2 à 5,
**caractérisé en ce que**
le dispositif (70) de détection est constitué par l'élément de chauffage-refroidissement lui-même.

**8.** Dispositif de mesure suivant l'une des revendications 1 à 7,
**caractérisé en ce que**
il est prévu un canal (50) de référence, qui débouche seulement dans une chambre (30) et auquel est associé un dispositif (60) de détection de référence ayant des propriétés électriques déterminées à l'avance.

**9.** Dispositif de mesure suivant l'une des revendications 1 à 8,
**caractérisé en ce que**
il est associé un dispositif (80) de détection supplémentaire ayant des propriétés électriques déterminées à l'avance au dispositif (70) de détection, dispositif (80) de détection supplémentaire qui est chauffé ou refroidi par le courant gazeux chauffé ou refroidi dont la température est modifiée par le dispositif (70) de détection se trouvant à la température de mesure dans le cas du sens du courant gazeux du dispositif (70) de détection au dispositif (80) de détection supplémentaire et qui, en réaction à cela, fournit un signal électrique de mesure à sa sortie (82 et 84) ou, dans le cas d'un sens du courant gazeux du dispositif (80) de détection supplémentaire au dispositif (70) de détection, ne fournit pas de signal de mesure à sa sortie (82 et 84).

**10.** Dispositif de mesure suivant la revendication 8,
**caractérisé en ce que**
le dispositif (70) de détection et le dispositif (80) de détection de référence sont rassemblés en un circuit de mesure en pont.

**11.** Dispositif de mesure suivant la revendication 9 ou 10,
**caractérisé en ce que**
à la fois le dispositif (70) de détection et le dispositif (60) de détection de référence ou le dispositif (80) supplémentaire de détection sont disposés dans ou sur une partie de bord d'une paroi ou sont constitués de la paroi.

**12.** Dispositif de mesure suivant la revendication 11,
**caractérisé en ce que**
la paroi est en matériau semi-conducteur.

**13.** Dispositif de mesure suivant l'une des revendications 9 à 12,
**caractérisé en ce que**
les chambres (20, 30) et les canaux (40, 50), les barres inclinées et/ou le canal (50) de référence du microcapteur (5) sont constitués en un substrat (10) semi-conducteur.

**14.** Dispositif de mesure suivant l'une des revendications 9 à 13,
**caractérisé en ce que**
le dispositif (80) de détection supplémentaire est constitué à l'intérieur d'au moins un canal (40).

**15.** Dispositif de mesure suivant l'une des revendications 1 à 14,
**caractérisé en ce que**
l'une des chambres (20, 30) a une membrane élastique fermant vis-à-vis de l'extérieur.

**16.** Dispositif de mesure suivant l'une des revendications 1 à 15,
**caractérisé en ce que**
les microcapteurs sont disposés en lignes et colonnes en forme de matrice et peuvent être commandés individuellement au moyen d'un circuit de commande.

**17.** Procédé de fabrication d'un dispositif de mesure constitué monolithiquement dans un substrat et ayant au moins un microcapteur (5), comprenant les stades dans lesquels :

- on constitue au moins deux chambres (20, 30) ayant un passage reliant les chambres (20, 30),
- on constitue un dispositif (70) de détection pour détecter un courant gazeux passant dans le passage, courant gazeux qui provient de diverses pressions régnant dans les chambres (20, 30),
- on remplit les chambres (20, 30) et le passage d'un gaz et
- on ferme les chambres (20, 30) d'une manière étanche au gaz vis-à-vis de l'extérieur,

**caractérisé**
**en ce que** l'on constitue le passage sous la forme d'un canal dans lequel est disposé le dispositif (70) de détection et
**en ce que** l'on constitue supplémentairement un canal (50) de référence débouchant seulement dans une chambre (30)
et ce que le procédé comprend, en outre, le stade dans lequel :

- on constitue un circuit d'exploitation pour intégrer un signal du dispositif de détection.

**18.** Procédé suivant la revendication 17,
**caractérisé en ce que**
la fermeture des chambres (20, 30) et du au moins un canal (40) mettant les chambres en communication s'effectue par l'écoulement d'une matière (17) de recouvrement, la matière de recouvrement étant telle que les chambres et les canaux ainsi que le canal (50) de référence ne sont pas remplis.

**19.** Procédé suivant la revendication 18,
**caractérisé en ce que**
l'écoulement de la matière (17) de recouvrement s'effectue en présence d'un gaz destiné à remplir les chambres (20, 30).

**20.** Procédé suivant la revendication 18 ou 19,
**caractérisé en ce que**
la matière (17) de recouvrement est un verre au borophospho-silicate (BPSG).

**21.** Procédé suivant la revendication 17,
**caractérisé en ce que**
on fabrique les chambres (20, 30), le au moins un canal (40) mettant les chambres en communication ainsi que le canal (50) de référence dans le substrat (10) ainsi que le dispositif (60) de détection ainsi que le dispositif (70 et 80) de détection de référence et supplémentaire de détection par les stades opératoires suivants :

- on revêt le substrat (10) d'une couche (11) sacrificielle, par exemple en $SiO_2$,
- on structure le dispositif (60) de détection ainsi que le dispositif (70 et 80) de détection de référence et supplémentaire de détection avec leurs lignes (61, 63, 71, 73, 81, 83) sur la couche (11) sacrificielle, par exemple au moyen d'un procédé d'attaque,
- on dépose une deuxième couche (13) sacrificielle,
- on dépose une couche (14) de recouvrement, par exemple en silicium polycristallin,
- on munit la couche (14) de recouvrement de trous (15) au moins en partie dans les zones sous lesquelles il faut ménager les chambres (20, 30) et/ou les canaux (40, 50),
- on enlève par attaque les deux couches (11 et 13) sacrificielles à travers les trous (15) dans la couche (14) de recouvrement pour fabriquer les chambres (20, 30) et/ou les canaux (40, 50).

**22.** Procédé suivant l'une des revendications 17 à 21,
**caractérisé en ce que**
au moins une partie des surfaces produites dans le substrat (10), qui forment les au moins deux chambres (20, 30) et le au moins un canal (40) les mettant en communication ainsi que le canal (50) de référence, est munie, avant la fermeture au moyen de la matière (17) de recouvrement, d'une couche (18) de blocage empêchant une diffusion du gaz de remplissage dans le matériau (10) semi-conducteur environnant ou au moins la diminuant.

**Fig 1**

**Fig 2**

Fig 3A

12
11
10A

Fig 3B

15
12   80   14
13
11
10A

Fig 3C

17
14
12
13
18   18   11
40   18   80   16   10A